# EUROPEAN PATENT APPLICATION

(11) **EP 4 787 437 A1**
(43) Date of publication of application: **05.08.2026**
(21) Application number: 24876274.2
(22) Date of filing: 22.08.2024
(51) Int. Cl.: H01L 25/16, H01L 23/492

(54) **POWER MODULE AND POWER CONVERSION DEVICE**

(30) Priority: 10.10.2023 CN 202311309838
(71) Applicant: Huawei Digital Power Technologies Co., Ltd., Shenzhen, Guangdong 518043 (CN)
(72) Inventor: OUYANG, Mize, Shenzhen, Guangdong 518043 (CN); MUNDING, Andreas, Shenzhen, Guangdong 518043 (CN); LIAO, Xiaojing, Shenzhen, Guangdong 518043 (CN); PENG, Hao, Shenzhen, Guangdong 518043 (CN); PALM, Lasse Petteri, Shenzhen, Guangdong 518043 (CN)
(74) Representative: Pfenning, Meinig & Partner mbB
(86) International application number: PCT/CN2024/114059
(87) International publication number: WO 2025/077454

(57) **Abstract**

A power module and a power conversion apparatus are disclosed. The power module includes a first substrate, a second substrate, and a conductive part. The first substrate and the second substrate are spaced apart from each other, and the conductive part is connected between the first substrate and the second substrate. A first chip is disposed on the first substrate or the second substrate. A surface that is of the first substrate and that faces the second substrate includes a first region and a second region surrounding the first region. The first region includes an inner island and a groove surrounding the inner island, and the groove is filled with solder. A mounting end surface of the conductive part faces the first region, and the mounting end surface of the conductive part is supported by the inner island. The mounting end surface of the conductive part is fastened to the solder, for the first chip to electrically connect to the conductive part. The inner island supports the conductive part, so that a thickness of the solder can be increased, and then soldering strength between the first substrate and the conductive part can be improved.

## Description

This application claims priority to Chinese Patent Application No. 202311309838.4, filed with the China National Intellectual Property Administration on October 10, 2023 and entitled "POWER MODULE AND POWER CONVERSION APPARATUS", which is incorporated herein by reference in its entirety.

### TECHNICAL FIELD

This application relates to the field of power change technologies, and in particular, to a power module and a power conversion apparatus.

### BACKGROUND

With the development of power electronics technologies, power modules have attracted more and more attention. The power module integrates a plurality of power semiconductors and insulation components, which features high integration, convenient assembly, and strong reliability compared with discrete package.

In a related technology, the power module may include a circuit board and a conductive element integrated on a surface of the circuit board, and the conductive element is soldered on the surface of the circuit board. Soldering strength between the conductive element and the circuit board is low, and a crack is likely to occur at a joint between the conductive element and the circuit board.

### SUMMARY

To resolve a technical problem, embodiments of this application provide a power module and a power conversion apparatus that have high connection strength and good electrical control stability.

According to a first aspect, this application provides a power module, including a first substrate, a second substrate, and a conductive part, where the first substrate and the second substrate are spaced apart from each other, the conductive part is connected between the first substrate and the second substrate, and a first chip is disposed on the first substrate or the second substrate.

A surface that is of the first substrate and that faces the second substrate includes a first region, the first region includes an inner island and a groove surrounding the inner island, and the groove is filled with solder; and a mounting end surface of the conductive part faces the first region, the mounting end surface of the conductive part is supported by the inner island, and the mounting end surface of the conductive part is fastened to the solder, for the first chip to electrically connect to the conductive part.

The first substrate and the second substrate are spaced apart from each other, and are electrically connected by using the conductive part, so that power density of the power module can be improved, and the first substrate is provided with the first chip. In the power module, the first chip may be a semiconductor field-effect transistor (Metal-Oxide-Semiconductor Field-Effect Transistor, MOSFET), which is referred to as a MOS transistor for short. The first chip can control the conductive part to turn on or off a current at a high frequency. Stress is generated when the conductive part turns on or off the current at the high frequency, so that a soldering joint between the conductive part and the first substrate is prone to break, thereby shortening a service life of the power module. The groove is filled with the solder, and the inner island can support the conductive part, to avoid that the solder between the conductive part and the first substrate is very thin (less than 10 µm) because the conductive part sinks when being soldered to the first substrate. This can increase a thickness (Bonded Line Thickness, BLT) of the solder soldered between the conductive part and the first substrate, thereby improving soldering strength between the conductive part and the first substrate. This reduces negative impact of intermetallic compound (Intermetallic Compound, IMC) growth and void agglomeration between the conductive part and the first substrate on the soldering strength between the conductive part and the first substrate when the conductive part and the first substrate are soldered. When the first substrate and the conductive part are soldered, an intermetallic compound can grow between metal in the first substrate and metal in the conductive part. If the solder soldered between the conductive part and the first substrate is thick enough, when the conductive part and the first substrate are soldered, intermetallic compound growth can match a coefficient of thermal expansion (Coefficient of Thermal Expansion, CTE), so that the void agglomeration in the solder is unlikely to occur, thereby preventing a decrease in the soldering strength between the conductive part and the first substrate, and prolonging the service life of the power module. The groove is provided in the first region of the first substrate, and the thickness of the solder soldered between the first substrate and the conductive part can be controlled by controlling a depth of the groove, so that a resistance value of an electrical connection between the conductive part and the first substrate is more conveniently controlled. By filling the groove with the solder, the soldering strength between the conductive part and the first substrate is increased, and the solder between the conductive part and the inner island is thinner, so that the resistance value of the solder between the conductive part and the first substrate is smaller, and a loss of the power module can be reduced. The resistance value of the solder between the conductive part and the first substrate is positively correlated with the thickness of the solder between the conductive part and the inner island.

With reference to the first aspect, in a possible implementation, the solder covers an end surface that is of the inner island and that faces the conductive part. The solder covers the inner island, so that a contact area between the mounting end surface of the conductive part and the solder can be increased, and the soldering strength between the conductive part and the first substrate can be improved.

With reference to the first aspect, in a possible implementation, a projection of the mounting end surface of the conductive part in a thickness direction of the power module is located in the first region, and an area of the mounting end surface of the conductive part is less than an area of the first region. The mounting end surface of the conductive part is completely located in the first region, so that the contact area between the mounting end surface of the conductive part and the solder can be increased, and the soldering strength between the conductive part and the first substrate can be improved.

With reference to the first aspect, in a possible implementation, the groove includes a bottom wall and a side wall surrounding the bottom wall, the side wall is connected to the second region and the bottom wall, the surface that is of the first substrate and that faces the second substrate further includes a second region surrounding the first region, and a projection area of an opening of the groove in a thickness direction of the first substrate is greater than an area of the bottom wall of the groove. This can make the groove easier to be processed and formed, and a groove forming process is simple. The groove can be formed by using processes such as etching, stamping, casting, and milling.

With reference to the first aspect, in a possible implementation, the groove includes a bottom wall and a side wall surrounding the bottom wall, the surface that is of the first substrate and that faces the second substrate further includes a second region surrounding the first region, the side wall is connected to the second region and the bottom wall, and a projection area of an opening of the groove in a thickness direction of the first substrate is less than an area of the bottom wall of the groove. After the groove is filled with the solder, the side wall of the groove has a better limiting effect on the solder, which helps improve soldering strength of the solder for connecting the conductive part and the first substrate.

With reference to the first aspect, in a possible implementation, a depth of the groove is D, and D≥10 µm. The inner island can support the conductive part, thereby reducing a degree of sinking of the conductive part when the conductive part and the first substrate are soldered, preventing the thickness of the solder from being excessively thin (less than 10 µm), and then improving the soldering strength between the conductive part and the first substrate. The groove is provided on the first substrate, so that a thickness of solder between the mounting end surface that is of the conductive part and that faces the first region and the bottom wall of the groove can be controlled by controlling the depth of the groove, which helps control the resistance value of the solder between the conductive part and the first substrate, and further helps control a resistance value of the power module. The resistance value of the solder is positively correlated with the thickness of the solder between the conductive part and the inner island.

With reference to the first aspect, in a possible implementation, the inner island includes a first end and a second end, the first end is connected to the bottom wall of the groove, the second end supports the conductive part, and in the thickness direction of the first substrate, a projection area of the first end is greater than a projection area of the second end. This is more convenient for forming the inner island. When the inner island is formed, the first region may be etched to form the groove, and an unetched part in the first region is reserved to form the inner island.

With reference to the first aspect, in a possible implementation, the inner island includes a first end and a second end, the first end is connected to the bottom wall of the groove, and in the thickness direction of the first substrate, a projection area of the first end is less than a projection area of the second end. When the groove is filled with the solder, the inner island can limit the solder, thereby improving connection strength between the solder and the first substrate.

With reference to the first aspect, in a possible implementation, the surface that is of the first substrate and that faces the second substrate further includes the second region surrounding the first region, and the end surface that is of the inner island and that faces the conductive part is flush with the second region. When the first region of the first substrate is etched to form the groove and the inner island, the first region is directly etched, and the inner island is reserved, and the inner island does not need to be re-processed, thereby simplifying a step of etching the first substrate.

With reference to the first aspect, in a possible implementation, the end surface that is of the inner island and that faces the conductive part is closer to the bottom wall of the groove than the second region. The inner island supports the conductive part, and therefore, the thickness of the solder between the conductive part and the inner island can reach a specific thickness range. When the groove is filled with the solder, a contact area between the conductive part and the solder is increased, thereby improving the soldering strength between the conductive part and the first substrate.

With reference to the first aspect, in a possible implementation, a side surface of the conductive part surrounds the mounting end surface of the conductive part and is connected to the mounting end surface, and the side surface of the conductive part is fastened to the solder. The mounting end surface that is of the conductive part and that faces the first region is embedded into the solder and is fastened to the solder, and a part of the side surface of the conductive part extends into the solder and is fastened to the solder. Both the side surface of the conductive part and the mounting end surface that is of the conductive part and that faces the first region are fastened to the solder, thereby increasing the connection area between the conductive part and the solder, and improving connection strength between the conductive part and the solder.

With reference to the first aspect, in a possible implementation, the surface that is of the first substrate and that faces the second substrate further includes the second region surrounding the first region, and the solder further covers a part of the second region close to the first region, so that a connection between the solder and the first substrate can be more stable.

With reference to the first aspect, in a possible implementation, the power module further includes a second chip, the first chip is disposed on the first substrate, the second chip is disposed on the second substrate, and the second chip is electrically connected to the conductive part.

With reference to the first aspect, in a possible implementation, the power module includes a capacitor disposed on the first substrate or the second substrate, where the capacitor is configured to implement filtering of a circuit architecture; and/or the power module includes a resistor disposed on the first substrate or the second substrate, where the resistor is configured to control a current of a circuit architecture. The capacitor can filter a clutter current flowing through the power module, and setting the resistor helps control a magnitude of the current flowing through the power module.

According to a second aspect, this application discloses a power conversion apparatus, including the power module according to the first aspect and a circuit board, where the circuit board is electrically connected to the power module.

### BRIEF DESCRIPTION OF DRAWINGS

To describe the technical solutions in embodiments of this application or in the background more clearly, the following briefly describes the accompanying drawings for describing embodiments of this application or the background.
FIG. 1 is a diagram of a structure of a power conversion apparatus according to an embodiment of this application;
FIG. 2 is a diagram of an application scenario of a photovoltaic power supply system according to an embodiment of this application;
FIG. 3 is a diagram of a structure of a power module according to an embodiment of this application;
FIG. 4 is a top view of a first substrate according to an embodiment of this application;
FIG. 5 is a diagram of a structure of a connection between a first substrate and a conductive part according to an embodiment of this application;
FIG. 6 is a sectional view of a first substrate according to an embodiment of this application;
FIG. 7 is a diagram of a structure of a connection between a first substrate and a conductive part according to another embodiment of this application;
FIG. 8 is a sectional view of a first substrate according to another embodiment of this application;
FIG. 9 is a sectional view of a first substrate according to another embodiment of this application;
FIG. 10 is a sectional view of a first substrate according to another embodiment of this application;
FIG. 11 is a diagram of a structure of a connection between a first substrate and a conductive part according to another embodiment of this application; and
FIG. 12 is a sectional view of a first substrate according to another embodiment of this application.

### Description of reference numerals:

1000: power conversion apparatus; 100: power module; 110: first substrate; 111: first region; 112: inner island; 112a: first end; 112b: second end; 113: groove; 113a: bottom wall; 113b: side wall; 114: second region; 115: solder; 120: second substrate; 130: conductive part; 131: mounting end surface; 132: side surface; 140: first chip; 150: second chip; 160: capacitor; 170: resistor; 180: lead; 200: circuit board; 300: energy storage battery; 400: inverter; 500: household device; 600: communication base station; and 700: photovoltaic module.

### DESCRIPTION OF EMBODIMENTS

To make the objectives, technical solutions, and advantages of this application clearer, the following further describes this application in detail with reference to the accompanying drawings.

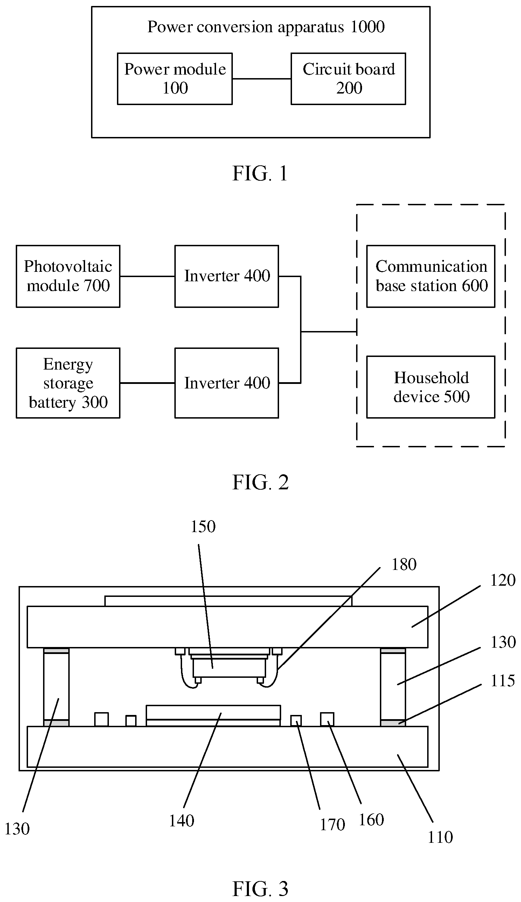

FIG. 1 is a diagram of a structure of a power conversion apparatus according to an embodiment of this application. A power conversion apparatus 1000 includes a power module 100 and a circuit board 200, and the circuit board 200 is electrically connected to the power module 100. The power conversion apparatus 1000 may be but is not limited to a power supply module, a rectifier, an inverter, a radio frequency apparatus, a selector, an on board charger (On Board Charger, OBC), an XPU, and the like, where the XPU is a general term of a series of processors such as a central processing unit (Central Processing Unit, CPU) and a graphics processing unit (Graphics Processing Unit, GPU).

The power conversion apparatus 1000 can serve as the power supply module used in a radio frequency unit (Remote Radio Unit, RRU). Specifically, the radio frequency unit includes the power supply module (the power conversion apparatus 1000), a transceiver, a power amplifier, and a filter. The power supply module can supply power to the transceiver, the power amplifier, and the filter. The transceiver can receive a signal and send a signal. The power amplifier can amplify the signal received by the transceiver, and the filter can filter out noise outside a preset frequency. The power supply module includes a power module, a circuit board, and an alternating current power supply. The alternating current power supply is connected to the power module and the circuit board. The circuit board can control on and off of the power module at a high frequency. It may be understood that the power supply module can supply power to or power off the transceiver, the power amplifier, and the filter at a high frequency.

For example, the power conversion apparatus 1000 is the on board charger. The on board charger can be used in a vehicle-mounted charging system. The vehicle-mounted charging system further includes an alternating current charging pile, a motor, and a vehicle-mounted battery. The alternating current charging pile charges the vehicle-mounted battery by using the on board charger, and the vehicle-mounted battery can supply power to the motor by using the on board charger.

To better explain the power conversion apparatus 1000, an example in which the power conversion apparatus 1000 is an inverter 400 is used. The inverter 400 is one of main components of a photovoltaic system. The inverter 400 may be configured to: convert a variable direct current voltage generated by a direct current power supply like a photovoltaic solar panel (namely, a photovoltaic module 700) into an alternating current with a mains frequency, and output the alternating current to a mains power grid (namely, an alternating current power grid) for use by the mains power grid, specifically, by a base station device or a household device 500 in the mains power grid.

FIG. 2 is a diagram of an application scenario of a photovoltaic power supply system according to this application. The photovoltaic power supply system provided in this application may include a direct current power supply and an inverter 400. The direct current power supply may include a photovoltaic array, an output end of the photovoltaic array may be connected to a first end of the inverter 400, and a second end of the inverter 400 is connected to an alternating current power grid. In the photovoltaic power supply system shown in FIG. 2, the photovoltaic array may include one or more photovoltaic strings connected in parallel, and one photovoltaic string may be obtained by connecting one or more photovoltaic modules 700 in series. The inverter 400 may change (may boost, buck, or the like) a direct current provided by the photovoltaic array, and supply power to a power consumption device like a battery, a communication base station 600, or a household device 500 in the alternating current grid after performing voltage inversion conversion on the direct current after voltage transformation.

In some feasible implementations, still refer to FIG. 2. The direct current power supply may further include an energy storage battery 300. An output end of the energy storage battery 300 may be connected to a first end of the inverter 400, and a second end of the inverter 400 is connected to the alternating current power grid. The inverter 400 may change (may boost, buck, or the like) a direct current provided by the energy storage battery 300, and supply power to a power consumption device like a battery, a communication base station 600, or a household device 500 in the alternating current grid after performing voltage inversion conversion on the direct current after voltage transformation.

In the application scenario shown in FIG. 2, in an actual mounting process of the photovoltaic module 700 and the inverter 400, positive and negative terminals of the photovoltaic module 700 may be reversely connected to positive and negative electrodes of an input end of the inverter 400. The reversely connected photovoltaic module 700 causes a reverse current to enter the inverter 400, thereby damaging the inverter 400 (for example, the reverse current damages a switching transistor in the inverter 400, causing an increase in heat consumption of the inverter 400). Currently, an anti-reverse connection diode may be added to a circuit of the inverter 400 to block a current path when the photovoltaic module 700 is reversely connected. However, adding an additional anti-reverse connection diode and a drive circuit to the inverter 400 causes the components of the inverter 400 to occupy an excessively large volume, affecting the power density of the inverter 400. In addition, the additional components require a higher internal heat dissipation capability of the inverter 400, increasing design costs.

In the photovoltaic power supply system provided in this application, the inverter 400 may include a direct current conversion circuit and an inverter circuit. A component like a switching transistor in the direct current conversion circuit may be integrated into a power module 100. One end of the power module 100 is connected to the photovoltaic module 700, and the other end of the power module 100 is connected to the inverter circuit. The power module 100, the direct current conversion circuit, and the inverter circuit can form a circuit architecture. The power module 100 may include a substrate, an insulation layer, a plurality of diodes, and the switching transistor (which may be a metal-oxide-semiconductor field-effect transistor (Metal-Oxide-Semiconductor Field-Effect Transistor, MOSFET), which is referred to as a MOS transistor for short, or may be an insulated gate bipolar transistor (insulated gate bipolar transistor, IGBT), or the like). The substrate and one surface of the insulation layer are soldered (which may be soldered by using a metal layer and a solder 115 layer), and both the plurality of diodes and the switching transistor and the other surface of the insulation layer are soldered (which may be soldered by using a metal layer and a solder 115 layer).

In a feasible implementation, refer to FIG. 3. FIG. 3 is a diagram of a structure of a power module according to an embodiment of this application. A power module 100 includes a first substrate 110, a second substrate 120, and a conductive part 130. The first substrate 110 and the second substrate 120 are spaced apart from each other. The conductive part 130 is connected between the first substrate 110 and the second substrate 120. The first substrate 110 and the second substrate 120 can be packaged by using an insulation material. The first substrate 110 may be a printed circuit board (Printed circuit board, PCB), the first substrate 110 may be a direct bond copper (Direct Bond Copper, DBC) substrate, or the first substrate 110 may be an active metal brazed (Active Metal Brazed, AMB) substrate. The second substrate 120 may be a printed circuit board (Printed circuit board, PCB), the second substrate 120 may be a direct bond copper (Direct Bond Copper, DBC) substrate, or the second substrate 120 may be an active metal brazed (Active Metal Brazed, AMB) substrate. A material of the first substrate 110 may be copper, or the first substrate 110 may be another substrate having a solderable or sinterable surface, for example, a metal substrate, an organic substrate, or a ceramic substrate. A material of the second substrate 120 may be copper, or the second substrate 120 may be another substrate having a solderable or sinterable surface, for example, a metal substrate, an organic substrate, or a ceramic substrate. There may be a plurality of conductive parts 130. The conductive part 130 may be but is not limited to an electronic component like a semiconductor chip, a capacitor, a resistor, or an inductor. The conductive part 130 may further be an electrical connector like a copper post or a silver post. The conductive part may be a structure connection element like an isolation post, a pillar, or a main board. The conductive part 130 is configured to electrically connect the first substrate 110 and the second substrate 120, and the conductive part 130 can also be configured to isolate and support the first substrate 110 and the second substrate 120. A first chip 140 is disposed on the first substrate 110 or the second substrate 120, and the first chip 140 may be but is not limited to a diode, a MOS transistor, or the like. In this application, an example in which the first chip 140 is disposed on the first substrate 110 is used. The first chip 140 can be directly soldered on the first substrate 110, or the first chip 140 can be electrically connected to the first substrate 110 through a lead 180. A second chip 150 is disposed on the second substrate 120. The second chip 150 can be directly soldered on the second substrate 120, or the second chip 150 can be electrically connected to the second substrate 120 through the lead 180. The second chip 150 may be but is not limited to a diode, a MOS transistor, or the like. The first substrate 110 and the second substrate 120 are connected by using the plurality of conductive parts 130. The first chip 140 is configured to control the conductive parts 130 to turn on or off a current. In the circuit architecture constructed by the power module 100, the second chip 150 is configured to control startup and shutdown of the circuit architecture. Generally, when the first chip 140 is turned off, the power module 100 is in an off state. When the first chip 140 is turned on, the first substrate 110 and the second substrate 120 are connected through the conductive parts 130, and the power module 100 is in an on state. For example, in the inverter 400, the circuit board 200 can control on/off states of the first chip 140 and the second chip 150. Specifically, the circuit board 200 sends a control signal to the first chip 140, and can control the first chip 140 to be turned on or off. The circuit board 200 sends a control signal to the second chip 150, and can control the second chip 150 to be turned on or off. The circuit board 200 can control a status of the power module 100 by controlling the first chip 140 to be turned on or off, and the status of the power module 100 includes the on state and the off state. The circuit board 200 can control the startup and shutdown of the circuit architecture by controlling the second chip 150 to be turned on or off.

In the power module 100 provided in this application, the power module 100 further includes a capacitor 160. The capacitor 160 is electrically connected to the first substrate 110 or the second substrate 120. There may be a plurality of capacitors 160. The capacitor 160 is configured to implement filtering of the circuit architecture. It should be noted that the capacitor 160 can filter a noise current that flows through the power module 100. The power module 100 further includes a resistor 170 disposed on the first substrate 110 or the second substrate 120. There may be a plurality of resistors 170. A magnitude of a current flowing through the circuit architecture can be controlled by using the resistor 170. It may be understood that a magnitude of a current flowing through the power module 100 can be controlled by disposing the resistor 170.

Two ends of each conductive part 130 are respectively soldered and connected to the first substrate 110 and the second substrate 120. Specifically, one end of the conductive part 130 is soldered to the first substrate 110 by using the solder 115, and the other end of the conductive part 130 is soldered to the second substrate 120 by using the solder 115. The solder 115 may be but is not limited to tin, silver, gold, or the like.

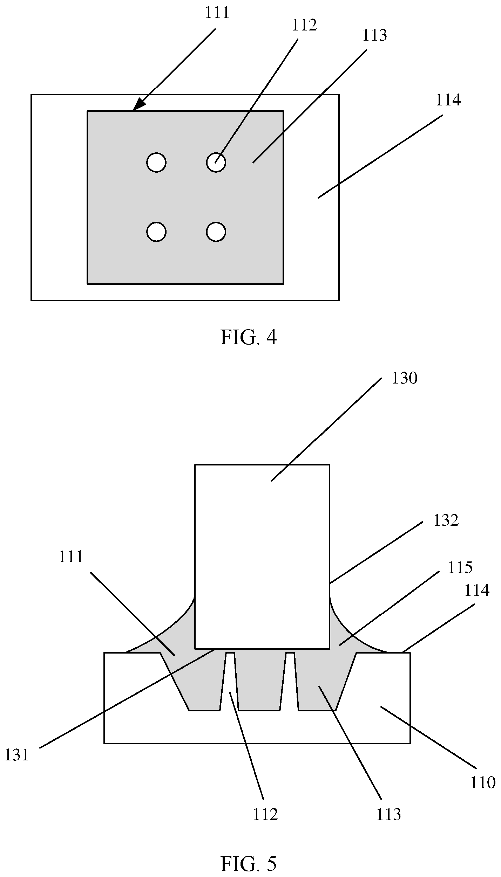

In a feasible implementation, refer to FIG. 4 and FIG. 5. FIG. 4 is a top view of a first substrate according to an embodiment of this application. FIG. 5 is a diagram of a structure of a connection between a first substrate and a conductive part according to an embodiment of this application. A surface that is of the first substrate 110 and that faces the second substrate 120 includes a first region 111 and a second region 114 surrounding the first region 111. The first region 111 includes an inner island 112 and a groove 113 surrounding the inner island 112. The groove 113 is filled with the solder 115. A part of a surface that is of the solder 115 and that faces the second substrate 120 may be flush with an end surface that is of the inner island 112 and that faces the conductive part 130. The solder 115 may also cover an end surface that is of the inner island 112 and that faces the second substrate 120. A mounting end surface 131 of the conductive part 130 faces the first region 111, the conductive part 130 is supported by the inner island 112, and an area of the mounting end surface 131 that is of the conductive part 130 and that faces the first region 111 is greater than an area of the end surface that is of the inner island 112 and that faces the conductive part 130. The mounting end surface 131 that is of the conductive part 130 and that faces the first region 111 is further fastened to the solder 115. A projection of the mounting end surface 131 of the conductive part 130 in a thickness direction of the power module is located in the first region 111, and the area of the mounting end surface 131 that is of first conduction and that faces the first region 111 is less than an area of the first region 111. The mounting end surface 131 that is of the conductive part 130 and that faces the first region 111 is completely located in the first region 111, so that a contact area between the mounting end surface 131 of the conductive part 130 and the solder 115 can be increased, thereby improving soldering strength. To further improve soldering strength between the conductive part 130 and the first substrate 110, the solder 115 further covers a part of the second region 114 close to the first region 111.

In a feasible implementation, a side surface 132 of the conductive part 130 surrounds the mounting end surface 131 that is of the conductive part 130 and that faces the first region 111, the mounting end surface 131 that is of the conductive part 130 and that faces the first region 111 is fastened to the solder 115, and the side surface 132 of the conductive part 130 is fastened to the solder 115. It may be understood that the mounting end surface 131 that is of the conductive part 130 and that faces the first region 111 is embedded into the solder 115 and is fastened to the solder 115, and a part of the side surface 132 of the conductive part 130 extends into the solder 115 and is fastened to the solder 115. Both the side surface 132 of the conductive part 130 and the mounting end surface 131 that is of the conductive part 130 and that faces the first region 111 are fastened to the solder 115, thereby increasing a connection area between the conductive part 130 and the solder 115, and improving connection strength between the conductive part 130 and the solder 115.

In the power module 100 provided in this application, both the first chip 140 and the second chip 150 may be MOS transistors. The first chip 140 can control the conductive part 130 to turn on or off a current at a high frequency. Stress is generated when the conductive part 130 turns on or off the current at the high frequency, so that a soldering joint between the conductive part 130 and the first substrate 110 is prone to break, thereby shortening a service life of the power module 100. The inner island 112 and the groove 113 surrounding the inner island 112 are disposed on the surface that is of the first substrate 110 and that faces the second substrate 120. The groove 113 is filled with the solder 115. The inner island 112 can support the conductive part 130, to avoid that the solder 115 between the conductive part 130 and the first substrate 110 is very thin (less than 10 µm) because the conductive part 130 sinks when being soldered to the first substrate 110. This can increase a thickness (Bonded Line Thickness, BLT) of the solder soldered between the conductive part 130 and the first substrate 110. In this application, the thickness of the solder is a thickness of the solder between the bottom wall of the groove and the mounting end surface of the conductive part, thereby improving soldering strength between the conductive part 130 and the first substrate 110, and further prolonging a service life of the power module. When the conductive part 130 and the first substrate 110 are soldered, intermetallic compound (Intermetallic Compound, IMC) growth occurs between the conductive part 130 and the first substrate 110. Therefore, if the solder between the conductive part 130 and the first substrate 110 is thin, it is difficult for the intermetallic compound growth to match a coefficient of thermal expansion (Coefficient of Thermal Expansion, CTE) during soldering, and void agglomeration is likely to occur, which negatively affects soldering strength between the conductive part 130 and the first substrate 110. If the solder soldered between the conductive part 130 and the first substrate 110 is thick enough, when the conductive part 130 and the first substrate 110 are soldered, the intermetallic compound growth can match the coefficient of thermal expansion, so that the void agglomeration in the solder 115 is unlikely to occur, thereby preventing a decrease in the soldering strength between the conductive part 130 and the first substrate 110. The groove 113 is provided in the first region 111 of the first substrate 110, and the thickness of the solder soldered between the first substrate 110 and the conductive part 130 can be controlled by controlling a depth of the groove 113, so that a resistance value of an electrical connection between the conductive part 130 and the first substrate 110 is more conveniently controlled. By filling the groove with the solder, the soldering strength between the conductive part and the first substrate is increased, and the solder between the conductive part and the inner island is thinner, so that the resistance value of the solder 115 between the conductive part 130 and the first substrate 110 is smaller, and a loss of the power module 100 can be reduced. The resistance value of the solder 115 between the conductive part 130 and the first substrate 110 is positively correlated with the thickness of the solder between the conductive part 130 and the inner island 112.

In the power module 100 provided in this application, to increase the thickness of the solder soldered between the conductive part 130 and the first substrate 110, the groove 113 is provided on the first substrate 110, and the inner island 112 is formed. A process used to achieve this objective is simple. When the groove 113 is provided on the first substrate 110, means such as but not limited to etching, stamping, grinding, casting, milling, and coating may be used, so that manufacturing costs of the power module 100 can be reduced.

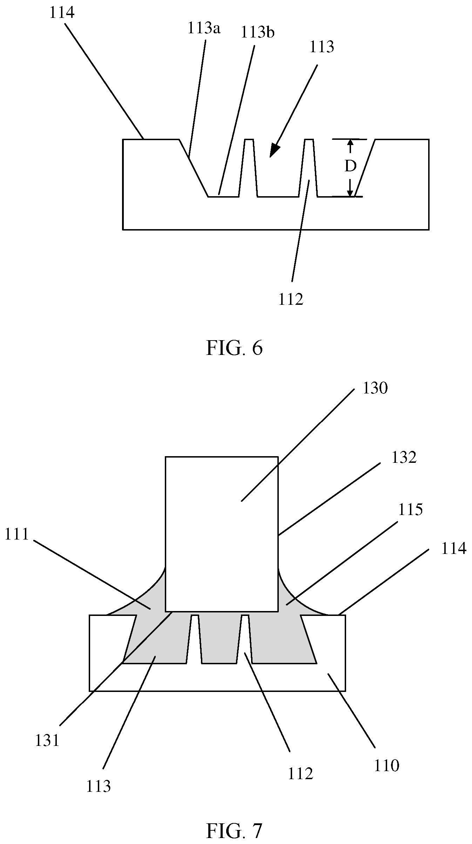

It should be noted that, refer to FIG. 5 and FIG. 6. FIG. 6 is a sectional view of a first substrate according to an embodiment of this application. A depth of the groove 113 provided in the first substrate 110 is D, and D≥10 µm. The inner island 112 can support the conductive part 130, thereby reducing a degree of sinking of the conductive part 130 when the conductive part 130 and the first substrate 110 are soldered, preventing the thickness of the solder 115 from being excessively thin (less than 10 µm), and then improving the soldering strength between the conductive part 130 and the first substrate 110. The groove 113 is provided on the first substrate 110, so that a thickness of the solder 115 between the mounting end surface 131 of the conductive part 130 and a bottom wall 113a of the groove 113 can be controlled by controlling the depth of the groove 113, which helps control the resistance value of the solder 115 between the conductive part 130 and the first substrate 110, and further helps control a resistance value of the power module 100. The resistance value of the solder 115 is positively correlated with the thickness of the solder between the conductive part 130 and the inner island 112.

In the power module 100 provided in this application, the groove 113 includes the bottom wall 113a and a side wall 113b, the side wall 113b surrounds the bottom wall 113a, and the side wall 113b is connected to the bottom wall 113a and the second region 114. The side wall 113b may be perpendicular to the bottom wall 113a, or the side wall 113b may be disposed obliquely.

In a feasible implementation, refer to FIG. 5. A projection area of an opening of the groove 113 in a thickness direction of the first substrate 110 is greater than an area of the bottom wall 113a of the groove 113. Specifically, the groove 113 may gradually shrink from a connection between the side wall 113b and the second region 114 to a connection between the side wall 113b and the bottom wall 113a. In this way, the groove 113 is easier to process and form, and a process of disposing the groove 113 may be but is not limited to etching, stamping, grinding, casting, milling, coating, and the like.

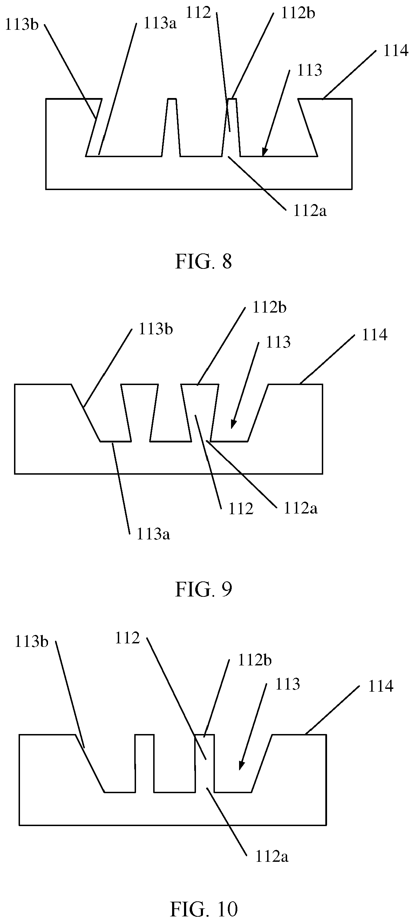

In a feasible implementation, refer to FIG. 7 and FIG. 8. FIG. 7 is a diagram of a structure of a connection between a first substrate and a conductive part according to another embodiment of this application. FIG. 8 is a sectional view of a first substrate according to another embodiment of this application. A projection area of an opening of the groove 113 in a thickness direction of the first substrate 110 is less than an area of the bottom wall 113a of the groove 113. The groove 113 gradually shrinks from a connection between the side wall 113b and the bottom wall 113a to a connection between the side wall 113b and the second region 114. After the groove 113 is filled with the solder 115, the side wall 113b of the groove 113 has a better limiting function for the solder 115, which helps improve soldering strength of the solder 115 for connecting the conductive part 130 and the first substrate 110. For example, the groove 113 may generally, but is not limited to, be in a shape of a prismatic frustum, a cuboid, a cylinder, or a truncated cone, and a cross section of the conductive part 130 may, but is not limited to, be in a shape of a circle, a rectangle, or the like. When the groove 113 is in a shape of a prismatic frustum or a cuboid, the cross section of the conductive part 130 may be set to a rectangle that adapts to the shape of the groove 113. When the groove 113 is in a shape of a cylinder or a truncated cone, the cross section of the conductive part 130 may be set to a circle that adapts to the shape of the groove 113. In this way, the conductive part 130 may be disposed at a central position of the first region 111, so that the conductive part 130 is more evenly stressed when being connected to the solder 115, thereby improving the soldering strength between the conductive part 130 and the first substrate 110.

In the power module 100 provided in this application, there may be a plurality of inner islands 112, the plurality of inner islands 112 are spaced apart from each other, the plurality of inner islands 112 may be arranged in an array, and the plurality of inner islands 112 may be arranged in a regular pattern. For example, the plurality of inner islands 112 may be arranged in a triangle, a quadrangle, a circle, a hexagon, or the like. The plurality of inner islands 112 are symmetrically disposed in a pattern, and each inner island 112 supports the conductive part 130, so that the conductive part 130 can be more evenly supported.

The inner island 112 includes a first end 112a and a second end 112b, the first end 112a is connected to the bottom wall 113a of the groove 113, and the second end 112b supports the conductive part 130.

In a feasible implementation, in the thickness direction of the first substrate 110, a projection area of the first end 112a is greater than a projection area of the second end 112b. Specifically, the inner island 112 gradually shrinks from the first end 112a to the second end 112b, which is more convenient for forming the inner island 112. When the inner island 112 is formed, the first region 111 may be etched to form the groove 113, and an unetched part in the first region 111 is reserved to form the inner island 112.

In a feasible implementation, refer to FIG. 9. FIG. 9 is a sectional view of a first substrate according to another embodiment of this application. In the thickness direction of the first substrate 110, a projection area of the first end 112a is less than a projection area of the second end 112b, and the inner island 112 gradually shrinks from the second end 112b to the first end 112a. When the groove 113 is filled with the solder 115, the inner island 112 can limit the solder 115, thereby improving connection strength between the solder 115 and the first substrate 110.

In a feasible implementation, refer to FIG. 10. FIG. 10 is a sectional view of a first substrate according to another embodiment of this application. Each section between the first end 112a and the second end 112b in the inner island 112 is the same.

The inner island 112 may be in a regular shape or an irregular shape, and the inner island 112 may, but is not limited to, be in a shape of a cylinder, a truncated cone, a cuboid, a prismatic frustum, or the like. The inner island 112 is in a regular shape, so that the inner island 112 is easily etched and formed in the first region 111, and the inner island 112 provides a more uniform support force for the conductive part 130.

In the power module 100 provided in this application, an end surface that is of the inner island 112 and that faces the conductive part 130 is flush with the second region 114. It may be understood that, when the first region 111 of the first substrate 110 is etched to form the groove 113 and the inner island 112, the first region 111 is directly etched, and the inner island 112 is reserved, and the inner island 112 does not need to be re-processed, thereby simplifying a step of etching the first substrate 110.

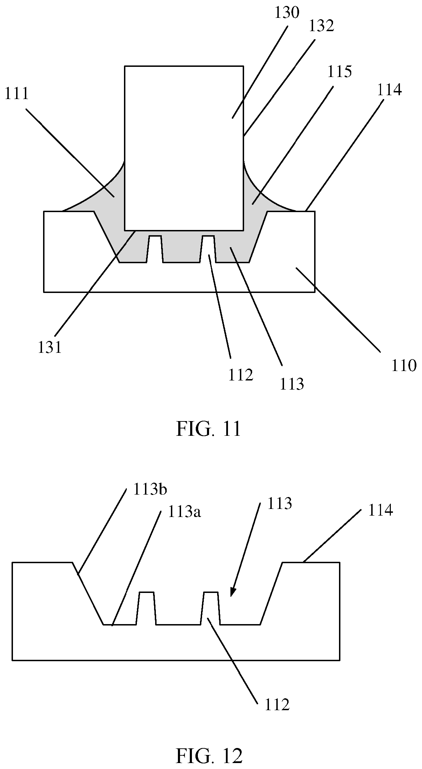

In a feasible implementation, refer to FIG. 11 and FIG. 12. FIG. 11 is a diagram of a structure of a connection between a first substrate and a conductive part according to another embodiment of this application. FIG. 12 is a sectional view of a first substrate according to another embodiment of this application. The end surface that is of the inner island 112 and that faces the conductive part 130 is closer to the bottom wall 113a of the groove 113 than the second region 114. It may be understood that, when the first region 111 of the first substrate 110 is etched, the first region 111 is etched to form the inner island 112 and the groove 113, and the inner island 112 is also etched. A thickness of etching the inner island 112 is less than a depth of the groove 113 formed by etching the first substrate 110, so that the end surface that is of the inner island 112 and that faces the conductive part 130 is closer to the bottom wall 113a of the groove 113 than the second region 114. Because the inner island 112 supports the conductive part 130, the thickness of the solder 115 between the conductive part 130 and the inner island 112 is generally within a specific range. When the solder 115 is filled in the groove 113, when the conductive part 130 is soldered to the first substrate 110, the conductive part 130 sinks and falls into the groove 113, and a contact area between the conductive part 130 and the solder 115 is increased. The inner island 112 supports the conductive part 130, so that a thickness between the conductive part 130 and the bottom wall 113a of the groove 113 is not excessively thin, thereby improving the soldering strength between the conductive part 130 and the first substrate 110.

In the power module 100 provided in this application, a soldering manner of the conductive part 130 and the second substrate 120 is the same as a soldering manner of the conductive part 130 and the first substrate 110. A structure form in which the second substrate 120 is provided with the groove 113 and forms the inner island 112 is the same as a structure form in which the first substrate 110 is provided with the groove 113 and forms the inner island 112. Details are not described in this application again.

"First", "second", and various numbers in this specification are merely used for differentiation for ease of description, but are not intended to limit the scope of this application.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

The foregoing embodiments are merely intended for describing the technical solutions of this application, but not for limiting this application. Although this application is described in detail based on the foregoing embodiments, a person of ordinary skilled in the art should understand that modifications may still be made to the technical solutions described in the foregoing embodiments or equivalent replacements may be made to some technical features, and such modifications or replacements do not cause the essence of the corresponding technical solutions to depart from the scope of the technical solutions of embodiments of this application.

## Claims

1. A power module, comprising a first substrate, a second substrate, and a conductive part, wherein the first substrate and the second substrate are spaced apart from each other, the conductive part is connected between the first substrate and the second substrate, and a first chip is disposed on the first substrate or the second substrate; and
a surface that is of the first substrate and that faces the second substrate comprises a first region, the first region comprises an inner island and a groove surrounding the inner island, and the groove is filled with solder; and a mounting end surface of the conductive part faces the first region, the mounting end surface of the conductive part is supported by the inner island, and the mounting end surface of the conductive part is fastened to the solder, for the first chip to electrically connect to the conductive part.

2. The power module according to claim 1, wherein the solder covers an end surface that is of the inner island and that faces the conductive part.

3. The power module according to claim 2, wherein a projection of the mounting end surface of the conductive part in a thickness direction of the power module is located in the first region, and an area of the mounting end surface of the conductive part is less than an area of the first region.

4. The power module according to any one of claims 1 to 3, wherein the groove comprises a bottom wall and a side wall surrounding the bottom wall, the surface that is of the first substrate and that faces the second substrate further comprises a second region surrounding the first region, the side wall is connected to the second region and the bottom wall, and a projection area of an opening of the groove in a thickness direction of the first substrate is greater than an area of the bottom wall of the groove.

5. The power module according to any one of claims 1 to 3, wherein the groove comprises a bottom wall and a side wall surrounding the bottom wall, the surface that is of the first substrate and that faces the second substrate further comprises a second region surrounding the first region, the side wall is connected to the second region and the bottom wall, and a projection area of an opening of the groove in a thickness direction of the first substrate is less than an area of the bottom wall of the groove.

6. The power module according to any one of claims 1 to 5, wherein a depth of the groove is D, and D≥10 µm.

7. The power module according to any one of claims 1 to 6, wherein the inner island comprises a first end and a second end, the first end is connected to the bottom wall of the groove, the second end supports the conductive part, and in the thickness direction of the first substrate, a projection area of the first end is greater than a projection area of the second end.

8. The power module according to any one of claims 1 to 6, wherein the inner island comprises a first end and a second end, the first end is connected to the bottom wall of the groove, and in the thickness direction of the first substrate, a projection area of the first end is less than a projection area of the second end.

9. The power module according to any one of claims 1 to 8, wherein the surface that is of the first substrate and that faces the second substrate further comprises the second region surrounding the first region, and the end surface that is of the inner island and that faces the conductive part is flush with the second region.

10. The power module according to any one of claims 1 to 8, wherein the surface that is of the first substrate and that faces the second substrate further comprises the second region surrounding the first region, and the end surface that is of the inner island and that faces the conductive part is closer to the bottom wall of the groove than the second region.

11. The power module according to any one of claims 1 to 10, wherein a side surface of the conductive part surrounds the mounting end surface of the conductive part and is connected to the mounting end surface, and the side surface of the conductive part is fastened to the solder.

12. The power module according to any one of claims 1 to 11, wherein the surface that is of the first substrate and that faces the second substrate further comprises the second region surrounding the first region, and the solder further covers a part of the second region close to the first region.

13. The power module according to any one of claims 1 to 12, wherein the power module further comprises a second chip, the first chip is disposed on the first substrate, the second chip is disposed on the second substrate, and the second chip is electrically connected to the conductive part.

14. The power module according to claim 13, wherein the power module comprises a capacitor disposed on the first substrate or the second substrate, and/or the power module comprises a resistor disposed on the first substrate or the second substrate.

15. A power conversion apparatus, comprising:
the power module according to any one of claims 1 to 14, and
a circuit board, wherein the circuit board is electrically connected to the power module.
